# EUROPEAN PATENT APPLICATION

(11) **EP 2 940 716 A1**
(43) Date of publication of application: **04.11.2015**
(21) Application number: 13867972.5
(22) Date of filing: 09.10.2013
(51) Int. Cl.: H01L 21/301

(54) **DICING-SHEET SUBSTRATE FILM AND DICING SHEET**

(30) Priority: 28.12.2012 JP 2012286709
(71) Applicant: LINTEC Corporation, Tokyo 173-0001 (JP)
(72) Inventor: TAYA Naoki, Tokyo 173-0001 (JP); UEDA Masashi, Tokyo 173-0001 (JP); ITO Masaharu, Tokyo 173-0001 (JP)
(74) Representative: Raynor, Stuart Andrew
(86) International application number: PCT/JP2013/077503
(87) International publication number: WO 2014/103468

(57) **Abstract**

A dicing sheet base film (2) includes a resin layer (A). The resin layer (A) contains: a polyethylene (a1) that has a density of 0.900 g/cm³ or more; and a styrene-based elastomer (a2). The polyethylene (a1) has a content of 50 mass% or more and 90 mass% or less to a total resin component contained in the resin layer (A), while the styrene-based elastomer (a2) has a content of 10 mass% or more and 50 mass% or less to the total resin component. The dicing sheet base film (2) suppresses the occurrence of dicing debris during the dicing of a cut object without imparting physical energy such as electron rays and γ rays, and has sufficient expandability in the expanding process.

## Description

### [Technical Field]

The present invention relates to a dicing sheet to which a cut object such as a semiconductor wafer is applied when the cut object is cut and separated into small element pieces, and also relates to a base film used for the dicing sheet.

### [Background Art]

Semiconductor wafers such as silicon and gallium arsenide wafers and various types of packages (which may be collectively referred to as "cut object(s)" hereinafter) are manufactured in a large diameter state, and these are cut and separated (diced) into small element pieces (referred to as "chip(s)" hereinafter).

A cut object to be supplied to the dicing process may be such that, for the purpose of ensuring the handling property of the cut object and chips in the dicing process and subsequent processes, a dicing sheet comprising a base film and a pressure sensitive adhesive layer provided thereon is preliminarily applied to a surface of the cut object opposite to the side which a cutting tool for cutting comes close to. Such a dicing sheet may typically use a polyolefin-based film or a polyvinyl chloride-based film as the base film, for example.

According to commonly-used full-cut dicing as a specific method for the dicing process, a rotating round blade is used for cutting a cut object. In the full-cut dicing, to ensure that the cut object applied thereto with the dicing sheet is completely cut over the entire surface, the pressure sensitive adhesive layer may also be cut beyond the cut object, and a part of the base film may further be cut.

During this operation, dicing debris comprising materials that constitute the pressure sensitive adhesive layer and the base film may arise from the dicing sheet, and the obtained chips may be contaminated with the dicing debris. One form of such dicing debris is filament-like dicing debris that attaches onto a dicing line or to an area near the cross-section of each chip separated by dicing.

If the chip is enclosed in a package while a large amount of the filament-like dicing debris as described above remains on the chip, then the filament-like dicing debris attached to the chip will be decomposed by heat used for the enclosing, and the thermally decomposed substance may destroy the package and/or cause operational failure in a device obtained. Such filament-like dicing debris is difficult to be removed by washing, and the yield of the dicing process will thus be considerably reduced due to the occurrence of filament-like dicing debris.

When dicing a package as the cut object in which plural chips are enclosed by using cured resin, a dicing blade having a thicker blade width is used and the cutting depth in dicing also becomes deeper than the case of dicing a semiconductor wafer. Consequently, the amount of the base film to be cut and removed during the dicing may increase compared with the case of a semiconductor wafer, and this may result in a tendency that the generated amount of filament-like dicing debris also increases. Therefore, when a dicing sheet is used to perform dicing, it is needed to prevent the occurrence of the filament-like dicing debris.

After the dicing process, the cut object having been cut may then be subjected to subsequent processes, such as washing, expanding and picking-up processes. As such, it is also required for a dicing sheet to have excellent expandability in the expanding process.

To suppress the occurrence of such dicing debris, Patent Literature 1 discloses an invention which uses, as the base film of a dicing sheet, a polyolefin-based film having been exposed to electron rays or γ (gamma) rays with 1-80 Mrad. In this invention, it appears that a resin that constitutes the base film is crosslinked through the exposure to electron rays or γ rays thereby to suppress the occurrence of dicing debris.

Patent Literature 1 exemplifies, as materials for the polyolefin-based film to be exposed to electron rays or γ rays, resins such as polyethylene, polypropylene, polymethylpentene, ethylene-vinyl acetate copolymer, ethylene-(meth)acrylic acid copolymer, ethylene-methyl (meth)acrylate copolymer, ethylene-ethyl (meth)acrylate copolymer, ethylene-ionomer copolymer, ethylene-vinyl alcohol copolymer, and polybutene.

Patent Literature 2 exemplifies a pressure sensitive adhesive tape for dicing a semiconductor in which: the tape is obtained by applying a pressure sensitive adhesive on one surface of a base film; the base film comprises at least two layers; the melting point of a resin in a layer of the base film that is in contact with the pressure sensitive adhesive layer is 130-240°C; at least one layer of the two layers is a resin composition layer that is in contact with the lower surface of the layer in contact with the pressure sensitive adhesive layer; and the resin composition layer comprises 20-400 mass parts of a hydrogenated product of styrene-butadiene copolymer to 100 mass parts of polypropylene-based resin.

Patent Literature 3 discloses, as a film imparted with expandability in the expanding process, a dicing film comprising: a base material layer that contains random propylene and olefin-based elastomer; and a pressure sensitive adhesive layer laminated on the base material layer.

### [Prior Art Literature]

### [Patent Literature]

| | |
|---|---|
| [Patent Literature 1] | JP05-211234A |
| [Patent Literature 2] | JP2005-174963A |
| [Patent Literature 3] | JP2011-216595A |

### [Summary of the Invention]

### [Problems to be solved by the Invention]

However, the film described in Patent Literature 1 has a tendency that the production cost increases compared with that of a standard base film, because the exposure to electron rays or γ rays is performed after the resin as described above is once formed into a film-like shape, and an additional process for production is required. The base film of Patent Literature 2 is not able to sufficiently prevent the occurrence of filament-like dicing debris. The dicing film described in Patent Literature 3 has excellent expandability, but is not able to sufficiently prevent the occurrence of filament-like dicing debris.

The present invention has been created in view of such actual circumstances, and an object of the present invention is to provide a base film for a dicing sheet which suppresses the occurrence of dicing debris, in particular filament-like dicing debris, during the dicing of a cut object without imparting physical energy such as electron rays and γ rays, and which has sufficient expandability (expanding property) in the expanding process. Another object of the present invention is to provide a dicing sheet that comprises such a base film for a dicing sheet.

### [Means for solving the Problems]

In order to achieve the above objects, first, the present invention provides a dicing sheet base film comprising a resin layer (A), the resin layer (A) comprising: a polyethylene (a1) that has a density of 0.900 g/cm³ or more at 23°C; and a styrene-based elastomer (a2), the polyethylene (a1) having a content of 50 mass% or more and 90 mass% or less to a total resin component contained in the resin layer (A), the styrene-based elastomer (a2) having a content of 10 mass% or more and 50 mass% or less to the total resin component (Invention 1).

Here, examples of the "dicing sheet" in the present invention include a dicing/die bonding sheet, and also include one which has another base film and pressure sensitive adhesive layer for being attached thereto with a ring frame. Further, the term "sheet" as used in the present invention encompasses the concept of a "tape."

The "styrene-based elastomer (a2)" in the present invention means a copolymer that contains a structural unit derived from styrene or its derivative (also referred to as a "styrene-based compound" in the present description), i.e., a material that has elasticity, like rubber, within a temperature region including an ordinary temperature and also has thermoplasticity.

According to the above invention, the resin layer (A) comprises the polyethylene (a1) and the styrene-based elastomer (a2) thereby to suppress the occurrence of filament-like debris during the dicing and also to allow the base film to have sufficient expandability in the expanding process. Therefore, dicing debris that is generated during the dicing of a cut object can effectively be reduced without imparting physical energy, such as electron rays and γ rays. Moreover, there can be obtained a base film having sufficient expandability in the expanding process.

In the above invention (Invention 1), it may be preferred that the styrene-based elastomer (a2) comprises a styrene-conjugate diene copolymer (Invention 2).

In the above invention (Invention 2), it may be preferred that the styrene-based elastomer (a2) contains at least one type selected from the group consisting of a styrene-butadiene copolymer and a styrene-isoprene copolymer (Invention 3).

In the above invention (Invention 1 to 3), it may be preferred that the styrene-based elastomer (a2) contains styrene with a content ratio of 5 mass% or more and 50 mass% or less (Invention 4).

In the above invention (Invention 1 to 4), it may be preferred that the styrene-based elastomer (a2) comprises a hydrogenated styrene-conjugate diene copolymer (Invention 5).

In the above invention (Invention 1 to 5), it may be preferred that the dicing sheet base film comprises a resin layer (B) placed at a side of one of surfaces of the resin layer (A), and the resin layer (B) comprises at least one layer (Invention 6).

In the above invention (Invention 6), it may be preferred that the resin layer (B) comprises at least one of a polypropylene, an ethylene-(meth)acrylic ester copolymer and an ethylene(meth)acrylic acid copolymer (Invention 7).

Second, the present invention provides a dicing sheet comprising: the dicing sheet base film according to any one of the above inventions (1 to 7) ; and a pressure sensitive adhesive layer placed on the resin layer (A) of the film (Invention 8).

### [Advantageous Effect of the Invention]

According to the dicing sheet base film and the dicing sheet of the present invention, dicing debris that is generated during the dicing of a cut object can effectively be reduced without imparting physical energy, such as electron rays and γ rays. Moreover, the dicing sheet base film having sufficient expandability in the expanding process can be obtained. Furthermore, the dicing sheet base film and the dicing sheet do not require any treatment using electron rays or γ rays, and can thus be easily manufactured.

### [Brief Description of Drawings]

[FIG. 1] FIG. 1 is a cross-sectional view of a dicing sheet according to an embodiment of the present invention.
[FIG. 2] FIG. 2 is a cross-sectional view of a dicing sheet according to another embodiment of the present invention.

### [Embodiments for Carrying out the Invention]

Description will now be directed to constitutional elements of a dicing sheet according to an embodiment of the present invention and a method of manufacturing the same, etc.

### 1. Base film

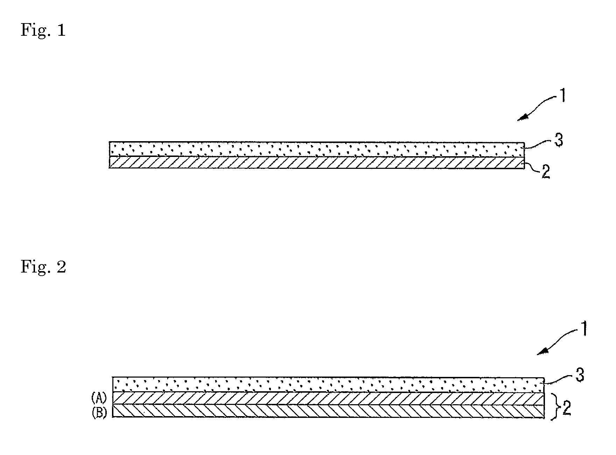

As shown in FIG. 1, dicing sheet 1 according to an embodiment of the present invention comprises, as a basic configuration, a base film 2 and a pressure sensitive adhesive layer 3 placed on the base film 2. This base film 2 comprises a resin layer (A), and may further comprise a resin layer (B) according to another embodiment (FIG. 2) as will be described later.

### (1) Resin layer (A)

The base film 2 may be a single layer or may comprise plural layers so long as the base film 2 comprises the resin layer (A). When the base film 2 comprises a single resin layer, the resin layer (A) as a single layer is the base film 2. When the base film 2 comprises plural resin layers, the location of the resin layer (A) is not particularly limited, but it may be preferred that at least one of main surfaces of the base film 2 is a surface of the above resin layer (A). In this case, for forming the pressure sensitive adhesive layer 3 on the base film 2 thereby to form the dicing sheet 1, it may be preferred that the pressure sensitive adhesive layer 3 is formed on the resin layer (A). Such a feature allows to effectively reduce the occurrence of dicing debris during the dicing of a cut object.

This resin layer (A) contains: a polyethylene (a1) that has a density of 0.900 g/cm³ or more at 23°C; and a styrene-based elastomer (a2).

The feature that the resin layer (A) contains the polyethylene (a1) allows prevention of blocking and can impart expandability. To stably obtain such effects, the polyethylene (a1) may preferably have a content of 50 mass% or more, more preferably 60 mass% or more, and particularly preferably 70 mass% or more, to the total resin components contained in the resin layer (A). However, if the polyethylene (a1) is excessively contained in the resin layer (A), the effect of suppressing the occurrence of dicing debris deteriorates. Therefore, the polyethylene (a1) may preferably have a content of 90 mass% or less, more preferably 85 mass% or less, and particularly preferably 80 mass% or less, to the total resin components contained in the resin layer (A). On the other hand, if the content of the polyethylene (a1) is less than 50 mass%, excellent expandability cannot be obtained, so that loosening and/or blocking may possibly occur.

The resin layer (A) of the base material 2 according to the present embodiment contains the styrene-based elastomer (a2) in addition to the polyethylene (a1). Containing the styrene-based elastomer (a2) can suppress the occurrence of dicing debris. In order to stably obtain this effect, the styrene-based elastomer (a2) in the resin layer (A) may preferably have a content of 10 mass% or more, and more preferably 20 mass% or more. However, if the styrene-based elastomer (a2) is excessively contained in the resin layer (A), the resin layer (A) is unduly softened to deteriorate the handling ability of the dicing sheet because blocking is likely to occur in the base material 2, for example. Therefore, the styrene-based elastomer (a2) may preferably have a content of 50 mass% or less, more preferably 45 mass% or less, and particularly preferably 40 mass% or less, to the total resin components contained in the resin layer (A).

Components that constitute the resin layer (A) will then be described in detail.

### (1-1) Polyethylene (a1)

The polyethylene (a1) contained in the resin layer (A) according to the present embodiment belongs to those as thermoplastic resins having a main component of polymer of which the monomer is ethylene, and is that which has a density of 0.900 g/cm³ or more at 23°C. The feature that the polyethylene (a1) satisfies the above condition of the density can provide an effect of improving the handling ability of the base film 2 (specific examples of such an effect include suppressing the dicing sheet 1 from excessively adhering to a dicing table, suppressing the occurrence of loosening during transportation, and avoiding the blocking). In order to more stably improve the handling ability of the resin layer (A), the density at 23°C of the polyethylene (a1) may preferably be 0.910 g/cm³ or more, more preferably 0.920 g/cm³ or more, and further preferably 0.950 g/cm³ or more. The upper limit of the density at 23°C of the polyethylene (a1) is not particularly limited, but may preferably be 1.000 g/cm³ or less in general, more preferably 0.990 g/cm³ or less, and further preferably 0.980 g/cm³ or less, in view of the handling ability.

Polymers that constitute the polyethylene (a1) may be of one type or may be obtained by blending plural types of polymers so long as the density of the polyethylene (a1) falls within the above range. The polyethylene (a1) may be any of a homopolymer or a copolymer of ethylene, but may preferably be a homopolymer. When the polyethylene is a copolymer, the content ratio of ethylene in the polyethylene (mass ratio of ethylene in the polymer) may preferably 20 mass% or more, more preferably 50 mass% or more, and further preferably 90 mass% or more.

Here, the polyethylene (a1) may have a crosslinked structure. Any type of crosslinking agent may be used to provide a crosslinked structure. The crosslinked structure may be crosslinked between polymer molecules of one type that constitute the polyethylene (a1), or crosslinked between polymer molecules of different types.

In order to suppress the occurrence of dicing debris, the polyethylene (a1) contained in the resin layer (A) according to the present embodiment may preferably have a value of melt flow rate in compliance with JIS K7210: 1999 of 0.1 g/10 min or more at a temperature of 230°C and a load of 2.16 kgf. In order to stably achieve the suppression of the occurrence of dicing debris, the melt flow rate of the polyethylene (a1) may preferably be 0.5 g/10 min or more and 10 g/10 min or less, and more preferably 2.0 g/10 min or more and 7 g/10 min or less.

The tensile elastic modulus at 23°C of the polyethylene (a1) is not particularly limited, but may ordinarily be 1.0 GPa or less, preferably 0.4 GPa or less, and more preferably 0.2 GPa or less. The tensile elastic modulus in the present description refers to a value that is measured at 23°C in compliance with JIS K7161: 1994 and JIS K7127: 1999 using a tensile tester (specifically, Autograph AG-IS 500N available from SHIMADZU CORPORATION).

The liquefaction temperature of the polyethylene (a1) is not particularly limited, but it may ordinarily be preferred that the liquefaction temperature is 100°C or higher and 180°C or lower.

### (1-2) Styrene-based elastomer

The resin layer (A) of the base film 2 according to the present embodiment contains the styrene-based elastomer (a2). In the present description, the "styrene-based elastomer (a2)" means a copolymer that contains a structural unit derived from styrene or its derivative (styrene-based compound), i.e., a material that has elasticity, like rubber, within a temperature region including an ordinary temperature and also has thermoplasticity. According to the feature that the resin layer (A) contains the styrene-based elastomer (a2), the occurrence of dicing debris is suppressed and the expandability is improved.

Examples of the styrene-based elastomer (a2) include a styrene-conjugate diene copolymer and a styrene-olefin copolymer. In order to improve the expandability while suppressing the occurrence of dicing debris, the styrene-based elastomer (a2) may preferably contain a styrene-conjugate diene copolymer, and may more preferably consist of a styrene-conjugate diene copolymer.

Specific examples of the styrene-conjugate diene copolymer include: non-hydrogenated styrene-conjugate diene copolymers, such as styrene-butadiene copolymer, styrene-butadiene-styrene copolymer (SBS), styrene-butadiene-butylene-styrene copolymer, styrene-isoprene copolymer, styrene-isoprene-styrene copolymer (SIS) and styrene-ethylene-isoprene-styrene copolymer; and hydrogenated styrene-conjugate diene copolymers, such as styrene-ethylene/propylene-styrene copolymer (SEPS, hydrogenated product of styrene-isoprene-styrene copolymer) and styrene-ethylene-butylene-styrene copolymer (SEBS, hydrogenated product of styrene-butadiene copolymer). Examples of the commercially available products in the industrial field include Tufprene (available from Asahi Kasei Corp.), Kraton (available from Kraton Polymer Japan), Sumitomo TPE-SB (available from Sumitomo Chemical Company, Limited), Epofriend (available from Daicel Corporation), Rabalon (available from Mitsubishi Chemical Corporation), Septon (available from KURARAY CO., LTD.) and Tuftec (available from Asahi Kasei Corp).

The styrene-based elastomer (a2) may be any of a hydrogenated product and a non-hydrogenated product. When the styrene-based elastomer (a2) is a hydrogenated product, the compatibility to the polyethylene (a1) is high, so that the total luminous transmittance of the resin layer (A) is enhanced. Therefore, when the pressure sensitive adhesive layer of the dicing sheet according to the present embodiment contains an ultraviolet curable-type pressure sensitive adhesive, it may be preferred that the styrene-based elastomer (a2) is a hydrogenated product. Examples of such a hydrogenated product include hydrogenated styrene-conjugate diene copolymers, such as styrene-ethylene-butylene-styrene copolymer (SEBS, hydrogenated product of styrene-butadiene copolymer) and styrene-ethylene/propylene-styrene copolymer (SEPS, hydrogenated product of styrene-isoprene copolymer). It may be particularly preferred that the styrene-based elastomer (a2) is such a hydrogenated styrene-conjugate diene copolymer.

In the total monomers used for forming the styrene-based elastomer (a2), the mass ratio of monomers comprising styrene-based compounds (referred also to as a "styrene content ratio" in the present description) may be 5 mass% or more and 50 mass% or less. If the styrene content ratio is unduly low, the property as an elastomer that contains a structural unit derived from styrene will be less likely to appear, and it may be difficult to obtain the effect of suppressing the occurrence of dicing debris. In order to stably obtain such an effect, the styrene content ratio may preferably be 5 mass% or more, and more preferably 10 mass% or more. If, on the other hand, the styrene content ratio is unduly high, it may be observed that the expandability of the base film 2 tends to deteriorate. Therefore, the styrene content ratio may preferably be 50 mass% or less, more preferably 40 mass% or less, and particularly preferably 25 mass% or less. The lower limit of the styrene content ratio may ordinarily be 5 mass% or more.

The styrene-based elastomer (a2) may be constituted of one type of resin, or may also be a mixture of plural types of resins.

Physical properties of the styrene-based elastomer (a2) are not particularly limited. Preferred properties include exhibiting rubber-like behavior as a physical property at an ordinary temperature.

### (1-3) Other components in resin layer (A)

The resin layer (A) may contain other components in addition to the above polyethylene (a1) and styrene-based elastomer (a2). Examples of such other components include: thermoplastic elastomer resins (excluding the styrene-based elastomer (a2)), such as isoprene rubber, nitrile rubber, acrylic rubber, urethane rubber, butadiene rubber and copolymers thereof; olefin-based thermoplastic resins (excluding the polyethylene (a1)), such as polypropylene; and various additives, such as pigment, flame retardant, plasticizer, antistatic, glidant and filler.

### (2) Resin layer (B)

When the base film 2 comprises a multilayer, the base film 2 may further comprise a resin layer (B) in addition to the above resin layer (A). In this case, the location of the resin layer (A) is not particularly limited, but it may be preferred that at least one of main surfaces of the base film 2 is a surface of the resin layer (A). Specifically, as shown in FIG. 2, it may be preferred that the base film 2 comprises the resin layer (B) formed of at least one layer which is placed at the side of one surface of the resin layer (A) and the dicing sheet 1 is configured by laminating the base film 2 and the pressure sensitive adhesive layer 3 on each other so that the pressure sensitive adhesive layer 3 is placed directly on the resin layer (A) of the base film 2.

When the base film 2 is a multilayer of the resin layer (A) and the resin layer (B) which are laminated on each other, there can be obtained advantages such as that the expandability of the base film 2 is improved.

Examples of resin that constitutes the resin layer (B) include: an olef in-based resin that is a resin based on a polymer containing a structural unit derived from an olefin compound; polyester such as polyethylene terephthalate and polyethylene naphthalate; polyurethane; polyvinyl chloride; and polyamide.

Among these resins, olefin-based resin may be preferred as the resin that constitutes the resin layer (B). When the resin that constitutes the resin layer (B) is an olefin-based resin, the interfacial adhesion of the resin layer (B) to the above-described resin layer (A) which contains the polyethylene (a1) and the styrene-based elastomer (a2) will be enhanced, and it is possible to more stably reduce the possibility that the delamination occurs between the resin layer (A) and the resin layer (B).

Examples of the above olefin-based resin include polyethylene, polypropylene, polybutene, ethylene-propylene copolymer, ethylene-butene copolymer, ethylene-(meth)acrylic acid copolymer, ethylene-vinyl acetate copolymer, and ethylene-(meth)acrylic ester copolymer. One type of the olefin-based resin may be solely used, or a mixture of two or more types of polymers may also be used.

Here, the "(meth)acrylic acid" as used in the present description is intended to mean both of acrylic acid and methacrylic acid. The "ethylene-(meth)acrylic acid copolymer" may be ethylene-acrylic acid copolymer, or ethylene-methacrylic acid copolymer, or ethylene-acrylic acid-methacrylic acid copolymer.

Among these copolymers, at least one kind of polypropylene, ethylene-(meth)acrylic ester copolymer and ethylene-(meth)acrylic acid copolymer may preferably be contained as a resin that constitutes the resin layer (B), because they allow the resin layer (B) to readily have enhanced toughness and to have enhanced interfacial adhesion to the resin layer (A) which contains the polyethylene (a1) and the styrene-based elastomer (a2), and excellent expandability can be obtained.

The ethylene- (meth) acrylic acid copolymer may contain a structural unit derived from other compounds to an extent that does not impair the effects of the present invention, other than the structural unit derived from ethylene, acrylic acid and/or methacrylic acid. Examples of such other compounds include: α-olefins such as propylene; and (meth) acrylic esters such as methyl (meth)acrylate and ethyl (meth)acrylate. It may be preferred that the mass ratio of monomers comprising such other compounds is a ratio of less than 10 mass% in the total monomers used for forming the ethylene-(meth)acrylic acid copolymer.

The polymer of the resin layer (B) may preferably contain 70 mass% or more, more preferably 80 mass% or more, and further preferably 90 mass% or more of the above at least one kind of polypropylene, ethylene-(meth)acrylic ester copolymer and ethylene-(meth)acrylic acid copolymer to the whole of resin that constitutes the resin layer (B).

It may be preferred that the resin layer (B) has a tensile elastic modulus of 50 MPa or more and 500 MPa or less and a fracture elongation of 100% or more. The tensile elastic modulus and the fracture elongation within the above ranges allow the resin layer (B) to have excellent flexibility and expandability, which can impart excellent expandability to the base film 2 configured such that the resin layer (A) and the resin layer (B) are laminated on each other.

If the tensile elastic modulus of the resin layer (B) exceeds 500 MPa, the flexibility of the resin layer (B) becomes poor so that the resin layer (B) readily fractures, and there is a concern that the expandability of the base film 2 deteriorates. On the other hand, the tensile elastic modulus of the resin layer (B) lower than 50 MPa may deteriorate the handling ability. Thus, the resin layer (B) may more preferably have a tensile elastic modulus of 55 MPa or more and 400 MPa or less, further preferably 60 MPa or more and 300 MPa or less, and particularly preferably 65 MPa or more and 200 MPa or less.

If the fracture elongation of the resin layer (B) is less than 100%, fracture readily occurs in the resin layer (B) when the dicing sheet 1 is expanded, and there is a concern that the expandability of the base film 2 deteriorates. More preferred fracture elongation of the resin layer (B) is 200% or more, and particularly preferred is 300% or more. The upper limit of the fracture elongation of the resin layer (B) is not particularly limited, but may ordinarily be 1,000% or less, and may also be about 800% or less.

The resin layer (B) may contain other components than the above resin to an extent that does not impair the effects of the present invention. Examples of such components include various additives, such as pigment, flame retardant, plasticizer, antistatic, glidant and filler. Examples of the pigment include titanium dioxide and carbon black. Examples of the filler include organic materials such as melamine resin, inorganic materials such as fumed silica, and metal-based materials such as nickel particles.

In the dicing sheet 1 according to the present embodiment, the resin layer (B) is constituted of a single resin layer, but may also have a structure comprising a plurality of resin layers. In addition, an interlayer such as an adhesive layer may be present between the resin layer (A) and the resin layer (B).

### (3) Other features of base film

When, as shown in FIG. 1, the base film 2 is a single layer of the resin layer (A), the thickness of the resin layer (A) (i.e., the base film 2) may ordinarily be 10 µm or more and 500 µm or less, preferably 40 µm or more and 300 µm or less, and more preferably 60 µm or more and 200 µm or less.

When, as shown in FIG. 2, the base film 2 is a multilayer comprising the resin layer (A) and the resin layer (B), the thickness of the base film 2 may ordinarily be 20 µm or more and 600 µm or less, preferably 40 µm or more and 300 µm or less, and more preferably 60 µm or more and 200 µm or less. In the total thickness of the base film 2, the thickness of the resin layer (A) which is a resin layer at the side in contact with the pressure sensitive adhesive layer 3 may ordinarily be 10 µm or more and 300 µm or less, preferably 20 µm or more and 120 µm or less, and more preferably 30 µm or more and 100 µm or less. The thickness of the resin layer (A) within the above range can prevent the occurrence of dicing debris. The thickness of the resin layer (B) may ordinarily be 10 µm or more and 300 µm or less, preferably 40 µm or more and 120 µm or less, and particularly preferably 50 µm or more and 100 µm or less.

The tensile elastic modulus (tensile elastic modulus at 23°C) of the base film 2 according to the present embodiment may be 50 MPa or more and 1,000 MPa or less, and preferably 80 MPa or more and 1,000 MPa or less. If the tensile elastic modulus is less than 50 MPa, the handling ability of the base film 2 may possibly be poor. If the tensile elastic modulus of the base film 2 exceeds 1,000 MPa, problems may occur such as that the base film 2 fractures in the expanding process and that the dicing sheet 1 itself is detached from a ring frame because the load applied during the expanding process increases.

### (4) Method of manufacturing base film

Method of manufacturing the base film 2 is not particularly limited. Examples thereof include: a melt extrusion method, such as T-die method and round-die method; a calender method; and a solution method, such as dry method and wet method, and any method may be employed. Considering that both the polyethylene (a1) and the styrene-based elastomer (a2) contained in the resin layer (A) are thermoplastic resins, it may be preferred to employ the melt extrusion method or the calender method. Among them, when the melt extrusion method is employed for manufacturing, components that constitute the resin layer (A) may be kneaded, and film forming may be performed using a known extruder directly from the obtained kneaded components or from pellets which have been once manufactured from the obtained kneaded components.

When the base film 2 has the resin layer (B), the method of manufacturing is also not particularly limited, and may be freely selected. Any suitable method may be employed depending on the composition of the resin layer (B) and purposes. For example, the resin layer (A) and the resin layer (B) may be laminated on each other using coextrusion molding, or separately manufactured resin layers may be applied to each other such as by adhesive so as to be laminated.

### 2. Dicing sheet

The dicing sheet comprises a pressure sensitive adhesive layer that is placed on the base film. More specifically, the dicing sheet 1 may preferably be configured such that the pressure sensitive adhesive layer 3 is placed on the resin layer (A) of the base film 2. According to the feature that the pressure sensitive adhesive layer 3 is formed on the resin layer (A), it is possible to effectively reduce the dicing debris which is generated during the dicing of a cut object.

### (1) Pressure sensitive adhesive layer

Examples of the pressure sensitive adhesive to be used that constitutes the pressure sensitive adhesive layer 3 include, but are not limited to, those which are usually used for dicing sheets, such as rubber-based, acrylic-based, epoxy-based, silicone-based and polyvinyl ether-based pressure sensitive adhesives, and energy ray curable-type (including ultraviolet curable-type) and heat curable-type pressure sensitive adhesives may also be used. When the dicing sheet 1 according to the present embodiment is used as a dicing/die-bonding sheet, adhesives may be used, such as pressure sensitive adhesive, thermoplastic adhesive and B-stage adhesive, which have both functions of fixing wafer and adhering die.

The thickness of the pressure sensitive adhesive layer 3 may ordinarily be 3-100 µm, and preferably about 5-80 µm.

### (2) Release sheet

A release sheet may be laminated on the pressure sensitive adhesive layer 3. The release sheet for protecting the pressure sensitive adhesive layer 3 may be freely selected.

The release sheet to be used may be, but is not particularly limited, a sheet that has a release layer formed on a substrate by release treatment using a release agent. Examples of the substrate used for the release sheet include glassine paper, coated paper, polyethylene film, polypropylene film, polybutene film, polybutadiene film, polymethylpentene film, polyvinyl chloride film, vinyl chloride copolymer film, polyethylene terephthalate film, polyethylene naphthalate film, polybutylene terephthalate film, polyurethane film, ethylene-vinyl acetate film, ionomer resin film, ethylene-(meth)acrylic acid copolymer film, ethylene- (meth) acrylic ester copolymer film, polystyrene film, polycarbonate film, polyimide film, fluorine resin film, and crosslinked films thereof. Laminate film obtained by laminating a plurality of such films may also be used.

Examples of the release agent used in the release treatment include alkyd-based, silicone-based, fluorine-based, unsaturated polyester-based, polyolefin-based and wax-based release agents.

The thickness of the release sheet may ordinarily be, but is not particularly limited to, about 20-150 µm.

### 3. Method of manufacturing dicing sheet

The method of manufacturing the dicing sheet 1 consisting of a laminate of the above base film 2 and pressure sensitive adhesive layer 3 and other layers, such as a release sheet, which may be used as necessary, is not particularly limited.

Some exemplary methods of manufacturing the dicing sheet 1 may be as follows.
(i) The pressure sensitive adhesive layer 3 is formed on the release sheet, and the base film 2 is pressed and bonded onto the pressure sensitive adhesive layer 3 to be laminated. In this operation, the method of forming the pressure sensitive adhesive layer 3 may be freely selected.
   One exemplary method of forming the pressure sensitive adhesive layer 3 may be as follows. A coating agent is prepared which contains a pressure sensitive adhesive that constitutes the pressure sensitive adhesive layer 3 and if necessary further contains some solvent. The coating agent is applied to one main surface of the base film 2 provided by the resin layer (A) using a coater, such as roll coater, knife coater, roll knife coater, air knife coater, die coater, bar coater, gravure coater, and curtain coater. The layer comprising the coating agent on the base film 2 is dried thereby to form the pressure sensitive adhesive layer 3.
(ii) The pressure sensitive adhesive layer 3 is formed on the base film 2, and if necessary a release sheet is further laminated thereon. In this operation, the method of forming the pressure sensitive adhesive layer 3 may be freely selected as the above.

In another example than the above methods of (i) and (ii), a pressure sensitive adhesive layer 3 separately formed in a sheet-like form may also be applied to the base film 2.

The embodiments heretofore explained are described to facilitate understanding of the present invention and are not described to limit the present invention. Therefore, it is intended that the elements disclosed in the above embodiments include all design changes and equivalents to fall within the technical scope of the present invention.

### [Examples]

The present invention will hereinafter be more specifically described with reference to examples etc, but the scope of the present invention is not limited to these examples etc.

### <Example 1>

### (Preparation of base film)

Raw material for extrusion of the resin layer (A) was obtained by melting and kneading 70 mass parts of low-density polyethylene (product name: SUMIKATHENE (registered trademark) L705, available from Sumitomo Chemical Company, Limited, density at 23°C: 0.919 g/cm³) as the polyethylene (a1) and 30 mass parts of a hydrogenated product of styrene-butadiene copolymer (SEBS, product name: Tuftec (registered trademark) H1221, available from Asahi Kasei Corp., styrene content ratio: 12 mass%) as the styrene-based elastomer (a2), using a biaxial kneading machine (Labo-plastomill available from Toyo Seiki Seisaku-sho, LTD).

The raw material for extrusion of the resin layer (A) was subjected to extrusion molding using a compact T die extruder (Labo-plastomill available from Toyo Seiki Seisaku-sho, LTD.), and a base film of single layer structure comprising the resin layer (A) having a thickness of 100 µm was obtained.

### (Preparation of pressure sensitive adhesive)

An energy ray curable-type pressure sensitive adhesive composition was obtained by mixing 100 mass parts of copolymer (Mw: 500,000) provided by copolymerization of 95 mass parts of n-butyl acrylate and 5 mass parts of acrylic acid, 120 mass parts of urethane acrylate oligomer (Mw: 8,000), 5 mass parts of isocyanate-based curing agent (Coronate L available fromNIPPON POLYURETHANE INDUSTRY CO., LTD.), and 4 mass parts of photopolymerization initiator (IRGACURE 184 available from Ciba Specialty Chemicals Inc).

The obtained energy ray curable-type pressure sensitive adhesive composition was applied to the release treatment surface of a release sheet treated with silicone treatment (SP-PET38111(S) available from LINTEC Corporation) to have a film thickness after drying of 10 µm, and dried at 100°C for 1 minute to form a pressure sensitive adhesive layer, which was then applied to the surface of the above base film at the side of the resin layer (A) thereby to transfer the pressure sensitive adhesive layer to the base film, and a dicing sheet was thus obtained.

### <Examples 2-7 and Comparative Examples 1-5>

Dicing sheets were manufactured in the same manner as that in Example 1 except that the materials for the resin layer (A) were changed to those listed in Table 1.

### <Example 8>

### (Preparation of base film)

Raw material for extrusion of the resin layer (A) was obtained by melting and kneading 70 mass parts of low-density polyethylene (product name: SUMIKATHENE (registered trademark) L705, available from Sumitomo Chemical Company, Limited, density at 23°C: 0.919 g/cm³) as the polyethylene (a1) and 30 mass parts of a hydrogenated product of styrene-butadiene copolymer (SEBS, product name: Tuftec (registered trademark) H1221, available from Asahi Kasei Corp., styrene content ratio: 12 mass%) as the styrene-based elastomer (a2), using a biaxial kneading machine (Labo-plastomill available from Toyo Seiki Seisaku-sho, LTD).

Raw material for extrusion of the resin layer (B) was obtained by melting and kneading ethylene-methacrylic acid copolymer (product name: ACRYFT (registered trademark) W201, available from Sumitomo Chemical Company, Limited) using a biaxial kneading machine (Labo-plastomill available from Toyo Seiki Seisaku-sho, LTD).

The raw material for extrusion of the resin layer (A) and the raw material for extrusion of the resin layer (B) were subjected to coextrusion molding using a compact T die extruder (Labo-plastomill available from Toyo Seiki Seisaku-sho, LTD.), and a base film of two-layer structure comprising the resin layer (A) having a thickness of 40 µm and the resin layer (B) having a thickness of 60 µm was obtained. The obtained base film was used to manufacture a dicing sheet in the same manner as that in Example 1.

### <Example 9>

A dicing sheet was manufactured in the same manner as that in Example 8 except that the type of resin for forming the resin film (B) was changed to random polypropylene (product name: Novatec PP FX4E, available from Japan Polypropylene Corporation).

Materials used in each example are as follows.

### <Resin layer (A) >

- Low-density polyethylene (product name: SUMIKATHENE (registered trademark) L705, available from Sumitomo Chemical Company, Limited, density at 23°C: 0.919 g/cm³, tensile elastic modulus at 23°C: 140 MPa)
- Linear low-density polyethylene (product name: Evolue (registered trademark) SP3505, available from Prime Polymer Co., Ltd., density at 23°C: 0.936 g/cm³)
- High-density polyethylene (product name: Novatec HF560, available from Japan Polyethylene Corporation, density at 23°C: 0.963 g/cm³)
- Ultralow-density polyethylene (product name: EXCELLEN VL200, available from Sumitomo Chemical Company, Limited, density at 23°C: 0.905 g/cm³)
- Ultralow-density polyethylene (product name: EXCELLEN EUL731, available from Sumitomo Chemical Company, Limited, density at 23°C: 0.895 g/cm³)
- Styrene-ethylene-butylene-styrene copolymer (hydrogenated product of styrene-butadiene copolymer) (SEBS, product name: Tuftec (registered trademark) H1041, available fromAsahi Kasei Corp., styrene content ratio: 30 mass%)
- Styrene-ethylene-butylene-styrene copolymer (hydrogenated product of styrene-butadiene copolymer) (SEBS, product name: Tuftec (registered trademark) H1221, available from Asahi Kasei Corp., styrene content ratio: 12 mass%)
- Styrene-ethylene/propylene-styrene copolymer (hydrogenated product of styrene-isoprene copolymer) (SEPS, product name: Kraton (registered trademark) G1730, available from Kraton Polymer Japan, styrene content ratio: 21 mass%)

### <Resin layer (B)>

- Ethylene-methyl methacrylate copolymer (product name: ACRYFT (registered trademark) W201, available from Sumitomo Chemical Company, Limited, tensile elastic modulus at 23°C: 65 Mpa)
- Random Polypropylene (product name: Novatec PP FX4E, available from Japan Polypropylene Corporation)

Compositions of the above examples and comparative examples are collectively listed in Table 1. Each numerical value in Table 1 represents the mass parts of each component.

**[Table 1]**

| Resin layer | Type of constitue nt resin | Name of material | Density at 23°c (g/cm³) | Examples | | | | | | | | | Comparative Examples | | | | |
|---|---|---|---|---|---|---|---|---|---|---|---|---|---|---|---|---|---|
| | | | | 1 | 2 | 3 | 4 | 5 | 6 | 7 | 8 | 9 | 1 | 2 | 3 | 4 | 5 |
| (A) | a1 | SUMIKATHENE L705 | 0.919 | 70 | 50 | 70 | 70 | - | - | - | 70 | 70 | - | 100 | - | - | - |
| | | EVOLUE SP3505 | 0.936 | - | - | - | - | 70 | - | - | - | - | - | - | - | - | - |
| | | NOVATEC HF560 | 0.963 | - | - | - | - | - | 70 | - | - | - | - | - | - | - | 100 |
| | | EXCELLEN VL200 | 0.905 | - | - | - | - | - | - | 70 | - | - | - | - | - | - | - |
| | | EXCELLEN EUL731 | 0.895 | - | - | - | - | - | - | - | - | - | - | - | 70 | - | - |
| | a2 | TUFTEC H1221 | | 30 | 50 | - | - | 30 | 30 | 30 | 30 | 30 | 100 | - | 30 | - | - |
| | | TUFTEC H1041 | | - | - | 30 | - | - | - | - | - | - | - | - | - | - | - |
| | | KRATON G1730 | | - | - | - | 30 | - | - | - | - | - | - | - | - | - | - |
| (B) | | ACRYFT W201 | | - | - | - | - | - | - | - | 100 | - | - | - | - | 100 | - |
| | | NOVATEC PP FX4E | | - | - | - | - | - | - | - | - | 100 | - | - | - | - | - |

### <Exemplary Test 1> (Observation of dicing debris)

After applying the pressure sensitive adhesive layer of each dicing sheet manufactured according to the examples and the comparative examples to an uncut BGA-type package module and then setting them on a dicing apparatus (DFD-651 available from DISCO Corporation), dicing was performed under the conditions below:
- work (adherend): silicon wafer;
- work size: 6 inches diameter, 350 µm thickness;
- dicing blade: 27HEEE available from DISCO Corporation;
- blade rotating speed: 50,000 rpm;
- dicing speed: 10 mm/sec;
- cut-into depth: cutting into the base film with a depth of 20 µm from the interface with the pressure sensitive adhesive layer; and
- dicing size: 10 mm×10 mm.

Thereafter, the cut chips were removed by irradiating ultraviolet rays (160 mJ/cm²) from the base film side. Among lengthwise and breadthwise dicing lines, one lengthwise line and one breadthwise line located near the respective centers were subjected to a test in which the number of filament-like debris particles of a length of 100 µm or more occurring on each line was counted using a digital microscope (VHX-100 available from KEYENCE CORPORATION, magnification: ×100). Measurement results were evaluated according to the criteria below. Evaluation results are listed in Table 2.
A: the number of filament-like debris particles was 0 to 10
B: 11 to 15
C: 16 or more

### <Exemplary Test 2> (Expandability test)

After applying a 6-inch silicon wafer to the pressure sensitive adhesive layer of each dicing sheet manufactured according to the examples and the comparative examples, the dicing sheet was attached to a flat frame and the wafer was fully cut into chips of 10 mm square using a diamond blade of 20 µm thickness. The dicing sheet was then pulled down 10 mm with a speed of 600 mm/min using an expanding jig (Die Bonder CSP-100VX available from NEC Machinery Corporation). Presence or absence of fracture of the dicing sheet at that time was confirmed. Results were evaluated according to the criteria below. Evaluation results are listed in Table 2.
A: when fracture was not confirmed under the above conditions
C: when fracture was confirmed under the above conditions

### <Exemplary Test 3> (Evaluation of handling ability)

When the above Exemplary Test 1 (Observation of dicing debris) was carried out, the dicing was performed using a fully-automatic dicing apparatus (DFD-651 available from DISCO Corporation). In this operation, the handling ability during from the supply of samples to the recovery thereof was evaluated according to the criteria below. Evaluation results are listed in Table 2.
A: when no particular problem occurred
A1: when little trouble occurred, but no problem in practical use
B: when at least one of the following troubles occurred: (1) troubles such as blocking occurred when the sample was reeled out after being wound up in a state of a base film for a dicing sheet; (2) some transport error occurred; and (3) the dicing sheet was loosened, after reattached to the wafer cassette, to be in contact with another dicing sheet placed on the lower stage.

**[Table 2]**

| Evaluation Items | Examples | | | | | | | | | Comparative Examples | | | | |
|---|---|---|---|---|---|---|---|---|---|---|---|---|---|---|
| | 1 | 2 | 3 | 4 | 5 | 6 | 7 | 8 | 9 | 1 | 2 | 3 | 4 | 5 |
| Observation of dicing debris | A | A | A | A | A | A | A | A | A | B | C | B | C | B |
| Expandability | A | A | A | A | A | A | A | A | A | A | A | A | A | C |
| Handling ability | A1 | A1 | A1 | A1 | A | A | A1 | A | A | B | A | B | A | A |

As apparent from Table 2, the dicing sheets manufactured according to the examples were less likely to generate dicing debris during the dicing process, and had excellent expandability during the expanding process and excellent handling ability during the dicing process.

### [Industrial Applicability]

The dicing sheet base film and the dicing sheet according to the present invention can be preferably used for dicing of semiconductor wafers and various kinds of packages, etc.

### [Description of Reference Numerals]

- 1: Dicing sheet
- 2: Base film (Resin layer (A) /Resin layer (B))
- 3: Pressure sensitive adhesive layer

## Claims

1. A dicing sheet base film comprising a resin layer (A), the resin layer (A) comprising: a polyethylene (a1) that has a density of 0.900 g/cm³ or more at 23°C; and a styrene-based elastomer (a2),
the polyethylene (a1) having a content of 50 mass% or more and 90 mass% or less to a total resin component contained in the resin layer (A), the styrene-based elastomer (a2) having a content of 10 mass% or more and 50 mass% or less to the total resin component.

2. The dicing sheet base film as recited in claim 1, wherein the styrene-based elastomer (a2) comprises a styrene-conjugate diene copolymer.

3. The dicing sheet base film as recited in claim 2, wherein the styrene-based elastomer (a2) contains at least one type selected from the group consisting of a styrene-butadiene copolymer and a styrene-isoprene copolymer.

4. The dicing sheet base film as recited in any one of claims 1 to 3, wherein the styrene-based elastomer (a2) contains styrene with a content ratio of 5 mass% or more and 50 mass% or less.

5. The dicing sheet base film as recited in any one of claims 1 to 4, wherein the styrene-based elastomer (a2) comprises a hydrogenated styrene-conjugate diene copolymer.

6. The dicing sheet base film as recited in any one of claims 1 to 5, wherein the dicing sheet base film comprises a resin layer (B) placed at a side of one of surfaces of the resin layer (A), and the resin layer (B) comprises at least one layer.

7. The dicing sheet base film as recited in claim 6, wherein the resin layer (B) comprises at least one of a polypropylene, an ethylene-(meth)acrylic ester copolymer and an ethylene(meth)acrylic acid copolymer.

8. A dicing sheet comprising: the dicing sheet base film as recited in any one of claims 1 to 7; and a pressure sensitive adhesive layer placed on the resin layer (A) of the film.
